Europäisches Patentamt

European Patent Office

Office européen des brevets

(11) Veröffentlichungsnummer: **0 061 512**
**B1**

# EUROPÄISCHE PATENTSCHRIFT

(45) Veröffentlichungstag der Patentschrift: **18.09.85**

(51) Int. Cl.⁴: **G 11 C 11/24**

(21) Anmeldenummer: **81102460.3**

(22) Anmeldetag: **01.04.81**

(54) **Integrierte Schaltungsanordnung zum Schreiben, Lesen und Löschen von Speichermatrizen mit Isolierschicht-Feldeffekttransistoren nichtflüchtigen Speicherverhaltens.**

(43) Veröffentlichungstag der Anmeldung:
**06.10.82 Patentblatt 82/40**

(45) Bekanntmachung des Hinweises auf die Patenterteilung:
**18.09.85 Patentblatt 85/38**

(84) Benannte Vertragsstaaten:
**DE FR GB IT NL**

(56) Entgegenhaltungen:
**DE-A-3 019 850**
**US-A-4 041 459**
**US-A-4 130 890**

**Intel-Datenbuch "The Semiconductor Memory Book 1978, J. Wiley & Son, New York**

(73) Patentinhaber: **Deutsche ITT Industries GmbH Hans-Bunte-Strasse 19 Postfach 840 D-7800 Freiburg (DE)**
(84) **DE**

(73) Patentinhaber: **ITT INDUSTRIES INC. 320 Park Avenue New York, NY 10022 (US)**
(84) **FR GB IT NL**

(72) Erfinder: **Adam, Fritz Günter Dr. rer.nat. Dipl.-Phys. Furtwänglerstrasse 10 D-7800 Freiburg i.Br. (DE)**

(74) Vertreter: **Stutzer, Gerhard, Dr. et al Deutsche ITT Industries GmbH Patent- und Lizenzabteilung Hans-Bunte-Strasse 19 Postfach 840 D-7800 Freiburg (DE)**

**Beschreibung**

Die Erfindung bezieht sich auf eine integrierte Schaltungsanordnung zum Schreiben, Lesen und Löschen von Speichermatrizen mit Isolierschicht-Feldeffekttransistoren nichtflüchtigen Speicherverhaltens, vgl. den Oberbegriff des Anspruchs 1. Derartige Speichermatritzen können z.B. aus MNOS-Transistoren, also solchen Feldeffekttransistoren aufgebaut werden, deren Gate-Isolierschicht aus zwei unterschiedlichen Materialien, z.B. Siliciumdioxid und Siliciumnitrid besteht. Eine weiter Gruppe derartiger Speichermatrizen benutzt die sogenannten Floating-Gate-Transistoren die, wie der Name bereits sagt, eine Gateelektrode aufweisen, die nach außen keine elektrische Verbindung hat.

Eine besondere Gruppe derartiger Floating-Gate-Transistoren ist in der Zeitschrift "1980 IEEE International Solid-State Circuits Conference, Digest of Technical Papers", Feb 1980, Seiten 152, 153 und 271 sowie ausführlicher in der Zeitschrift "Electronics", 28 Februar 1980, Seiten 113 bis 117 beschrieben. Das Charakteristische dieser Art von Floating-Gate-Transistoren ist, daß sie mit reinem Tunneleffekt ohne die Beteiligung heißer Ladungsträger arbeiten, so daß dür die Zwecke der vorliegenden Beschreibung Speicherzellen unter Verwendung dieser bekannten Floating-Gate-Transistoren als TUSIS-Speicherzellen bezeichnet werden, wobei das Akronym aus der englischen Bezeichnung Tunnel Single Injector Storage Cell abgeleiter ist.

Eine andere Variante derartiger mit dem Tunneleffekt arbeitender Floating-Gate-Transistoren ist in der älteren europäischen Anmeldung 81 10 1105.5, die auf die deutsche Patentanmeldung P 30 07 892.3—53 zurückgeht, offenbart. Für diese Variante bietet sich für die Zwecke der vorliegenden Beschreibung die Bezeichnung TITEF-Speicherzellen an, wobei das Akronym aus der Bezeichnung Tunnel-Injektor Tunnel-Emitter, Floating-Gate hervorgegangen ist.

Zum Betrieb von derartigen Speichermatrizen mit nicht-flüchtigem Speicherverhalten sind Schaltungsanordnungen zum Schreiben Lesen und Löschen erforderlich, die auch als Peripherieschaltung bezeichnet werden. Die bisher hierfür verwendeten Schaltungen sind Isolierschicht-Feldeffekttransistor-Schaltungen, also kurz MOS-Schaltungen, die in Einkanal-Technik realisiert sind, d.h. mit Transistoren eines einzigen Kanalleitungstyps. Da in derartigen Einkanal-Schaltungen auch im Ruhezustand immer eine Ruhestrom fließt, wächst der Strombedarf der aus der Speichermatrix und der Peripherieschaltung bestehenden Gesamtschaltung mit zunehmender Speichergröße so stark an, daß die Realisierung der Gesamtschaltung nicht mehr sinnvoll erscheint. Im Falle der erwähnten TUSIS-bzw. TITEF-Speicherzellen, die zum Programmieren nur vernachlässigbar kleine Ströme benötigen, kommt dieser Vorteil somit überhaupt nicht zum Tragen da die bisherigen Peripherieschaltungen mit ihrem großen Stromverbrauch ihn überdecken. Hier will die in den Ansprüchen gekennzeichnete Erfindung Abhilfe schaffen; ihr liegt die Aufgabe zugrunde, eine integrierte Schaltungsanordnung zum Schreiben Lesen und Löschen der erwähnten Speichermatrizen anzugeben, die einen vernachlässigbar kleinen Stromverbrauch, insbesondere Ruhestromverbrauch, aufweist. Der Grundgedanke der Erfindung ist es, das Adressieren und Programmieren (Löschen und Schreiben) vollständig in "CMOS-Manier" durchzuführen und auch das Auslesen weitestgehend nach den Prinzipien der CMOS-Technik durchzuführen. Die Grundelemente der Erfindung sind dabei in CMOS-Technik realisierte Potentialauswahlschaltungen für die Zeilen- und die Spalten-Ansteuerung sowie der Aufbau eines das CMOS-Inverter-Verhalten aufweisenden Ein-Aus-N-Decoders, was durch adressen- und ausgangsseitiges Parallelschalten eines Eins-Aus-N-Sperrdecoders aus Transistoren des einen Kanalleitungstyps und eines Eins-Aus-N-Kurzschlußdecoders aus Transistoren des anderen Kanalleitungstyps erreicht wird, der in einer eigenen Isolierwanne des einen Kanalleitungstyps angeordnet ist. Da im Sperrdecoder nur der adressierte Stromzweig gesperrt und alle anderen leitend sind, im Kurzschlußdecoder jedoch nur der adressierte Stromzweig leitend und alle anderen gesperrt sind, ergibt sich durch das adressen- und ausgangsseitige Parallelschalten sowohl für die beiden adressierten als auch für alle nichtadressierten Stromzweige das Verhalten von CMOS-Invertern.

Ein Vorteil der Erfindung ist darin zu sehen, daß es aufgrund ihres Aufbaus nach den Prinzipien der CMOS-Technik möglich ist, Speichermatrizen mit nichtflücktigem Speicherverhalten inklusive ihrer Peripherieschaltungen auf einem einzigen Halbleiterkristall zu integrieren, und daß diese Gesamschaltung nur geringfügigen Strom verbrauch so daß jeder beliebig lange Stand-by-Betrieb möglich ist.

Die Erfindung wird nun anhand von Ausführungsbeispielen, die in den Figuren der Zeichnung dargestellt sind, näher erläutert.

Fig. 1 zeigt das schematische Schaltbild einer ersten Ausführungsform der Erfindung für TITEF-Speicherzellen,

Fig. 2 zeigt das Schaltbild eines Ausführungsbeispiels der Erfindung für TUSIS-Speicherzellen,

Fig. 3 zeigt zwei Varianten von TITEF-Speicherzellen sowie eine Potential-Zuordnungstabelle,

Fig. 4 zeigt zwei Varianten von TUSIS-Speicherzellen sowie eine entsprechende Potential-Zuordnungstabelle,

Fig. 5 zeigt die den Dezimalzahlen 0 bis 15 zugeordneten Binärzahlen,

Fig. 6 zeigt das beispielhafte Schaltbild eines im Rahmen der Erfindung verwendbaren Sperrdecoders,

Fig. 7 zeigt das beispielhafte Schaltbild eines im Rahmen der Erfindung verwendbaren Kurzschlußdecoders,

Fig. 8 zeigt das Schaltbild der im Rahmen der Erfindung verwendbaren Spaltenpotential-Auswahlschaltung,

Fig. 9 zeigt das Schaltbild einer im Rahmen der Erfindung verwendbaren Zeilenpotential-Auswahlschaltung,

Fig. 10 zeigt das bei TITEF-Speichermatritzen zu verwendende Komplexgatter,

Fig. 11 zeigt das bei TUSIS-Transistoren zu verwendende Vielfachgatter und

Fig. 12 zeigt das ausfürliche Schaltbild der bei der Erfindung zu verwendenden CMOS-Transmission-Gates.

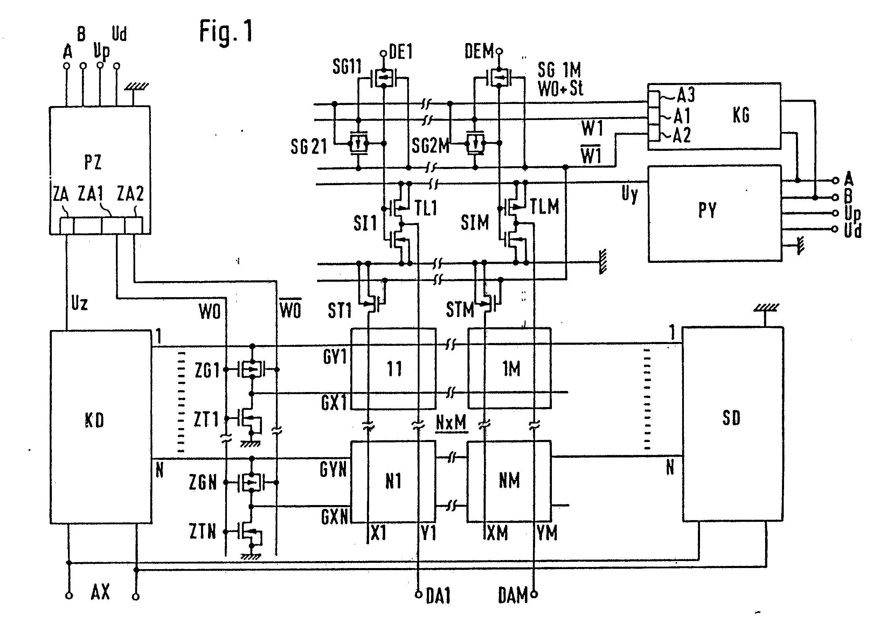

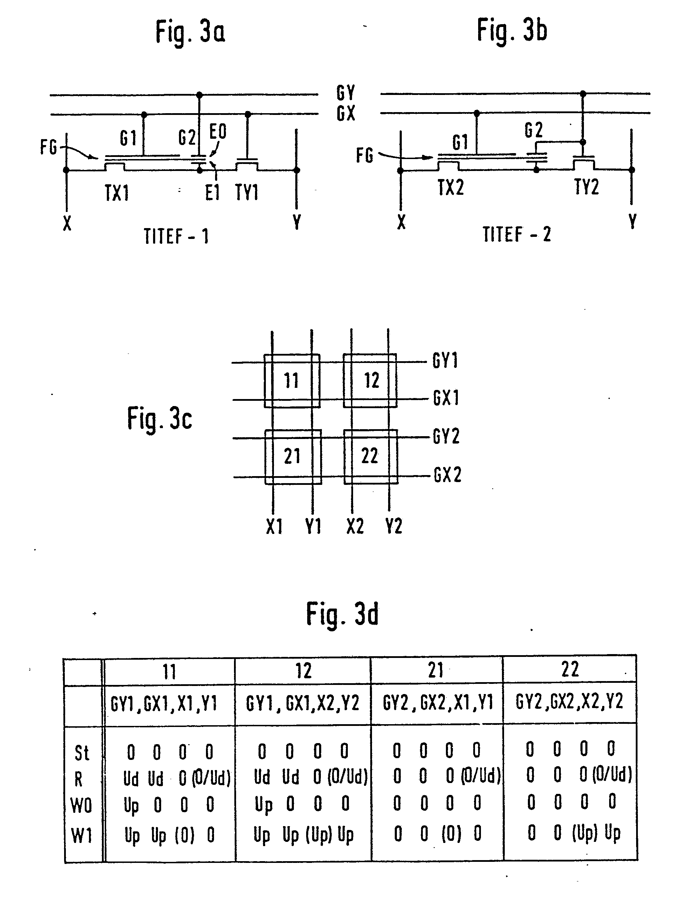

Das in Fig. 1 gezeigte schematische Schaltbild eines Ausführungsbeispiels der Erfindung für TITEF-Speicherzellen zeigt stellvertretend für die Speichermatrix N×M die aus den vier Speicherzellen 11, 1M, N1, NM aufgebaute Matrix. Zwei mögliche Varianten derartiger TITEF-Speicherzellen sind in Fig. 3a und b gezeigt und dort mit TITEF-1 bzw. mit TITEF-2 bezeichnet. Die einzelne Speicherzelle besteht dabei aus dem Speichertransistore TX1 bzw. TX2 und dem zu dessen Schaltstrecke mit seiner Schaltstrecke in Serie geschalteten Auswahltransistor TY1 bzw. TY2, welcher Transistor in der eingangs genannten Literaturstelle aus der Zeitschrift "Electronics" als Selecttransistor bezeichnet ist, Speicher- und Auswahltransistor sind vom gleichen Kanalleitungtyp; in sämtlichen Figuren ist vorausgesetzt, daß dies der N-Typ ist. Die Serienschaltung der Schaltstrecken von Speicher- und Auswahltransistor ist zwischen die speichertransistorseitige erste Spaltenleitung X— in Fig. 3c X1, X2 und in Fig. 1 X1 und XM—und die zweite Spaltenleitung Y bzw. Y1, Y2 bzw. Y1, YM geschaltet.

Der Speichertransistor TX1, TX2 hat die beiden äusseren Gates G1, G2, wobei das erste Gate G1 eine größere Fläche als das zweite Gate G2 aufweist und an der ersten Zeilenleitung GX bzw. GX1, GX2 bzw. GX1, GXN liegt.

Bei den TITEF-Speicherzellen nach den Fig. 3a und b dient das zweite Gate G2 als äussere Tunnelelektrode zum Schreiben einer Null (L), die zum Löschen verwendet wird. Der äusseren Tunnelelektrode ist die ebenfalls kleinflächige, mit dem Werbindungspunkt von Speicher- und Auswahltransistor verbundene innere Tunnelelektrode für das Schreiben zugeordnet. Das Löschen erfolgt dabei durch Tunnel-Emission von Elektronen aus dem Floating-Gate FG über die Strecke E0, wodurch die effektive, von der ersten Zeilenleitung GX aus gesehene Schwellenspannung des Speichertransistors erniedrigt wird. Das Schreiben erfolgt durch Tunnel-Injektion in das Floating-Gate FG über die Strecke E1, wodurch die effektive Schwellenspannung vergrößert wird.

Bei der TITEF-1-Speicherzelle nach Fig. 3a liegt das Gate des Auswahltransistors TY1 an der ersten Zeilenleitung GX, während es bei der TITEF-2-Speicherzelle nach Fig. 3b an der zweiten Zeilenleitung GY angeschlossen ist.

Für die in Fig. 3C gezeigte einfache Speichermatrix mit zwei Zeilen und zwei Spalten entsprechend den Speicherzellen 11, 12, 21, 22 ist in der Tabelle der Fig. 3d die Zuordnung der Potentiale an der ersten und zweiten Zeilenleitungen sowie ersten und zweiten Spaltenleitungen angegeben, und zwar in Abhängigkeit von den Betriebsweisen St: Warten (stand by), R: Lesen der Speicherzellen 11, 12; W0: Löschen der Speicherzellen 11, 12; W1: Schreiben der Speicherzelle 11. Die in diesem tabellenartigen Programmierschema der Fig. 3d nicht in Klammern stehenden Potentiale werden den entsprechenden Leitungen von außen zugeführt. Die in den Klammern stehenden Potentiale stellen sich wie folgt ein:

a) beim Lesen (R) entsprechend der programmierten Schwellenspannung des Speichertransistors TX: nach dem Löschen (W0) auf 0 und nach dem Schreiben (W1) auf Ud, wobei 0 in diesem Fall das Low-Ausgangspotential eines Ratio-Inverters ist; und

b) beim Schreiben (W1) entsprechend den Potentialen der zweiten Spaltenleitungen der geschriebenen Zeile, während die ersten Spaltenleitung beim Schreiben vom Schaltungsnullpunkt getrennt werden.

In Fig. 1 sind der Kurzschluß-Decoder KD und der Sperrdecoder SD einander gegenüberliegend zu beiden Seiten der Speichermatrix N×M angeordnet gezeigt. Die Addresseneingänge AX beider Decoder sind jeweils miteinander verbunden, d.h. beiden Decodern wird dieselbe Zeilenadresse zugeführt. Die Zeilenausgänge 1 bis N sind über die zweiten Zeilenleitungen GY1, GYN, die auch als Wortleitungen bezeichnet werden können, miteinander verbunden.

In Fig. 1 ist pro Speicherzeile 1 ... N das Zeilen-Transmission-Gate ZG1, ZGN vorgesehen, dessen Schaltstrecke zwischen der ersten und der zweiten Zeilenleitung GX1, GY1; GXN, GYN jeder Speicherzeile liegt, und der ebenfalls pro Speicherzeile vorgesehene Zeilentransistor ZT1, ZTN von einem Kanalleitungstyp—das ist Fig. 1 also ein N-Kanal-Transistore—verbindet die jeweilige erste Zeilenleitung GX1, GXN mit dem Schaltungsnullpunkt. Somit bilder der jeweilige Zeilentransistor ZT1, ZTN und der dazu komplementäre Teiltransistor des Zeilentransmission-Gates ZG1, ZGN einen CMOS-Inverter, der zwischen dem Schaltungsnullpunkt und der zweiten Zeilenleitung GY1, GYN liegt; in Fig. 1 ist dieser Teiltransistor des Zeilentransmission-Gates der links gezeichnete. Die Gates dieser beiden CMOS-Invertertransistoren sind miteinander verbunden und werden vom ersten Zusatz-Potentialausgang ZA1 der Zeilenpotential-Auswahlschaltung PZ mit dem Signal W0 angesteuert, während der andere Transistor des Zeilen-Transmission-Gates vom zweiten Zusatz-Potentialausgang ZA2 der Zeilenpotential-Auswahlschaltung mit dem zum

Signal W0 komplementären Signal $\overline{W0}$ angesteuert wird.

In Fig. 1 ist jede erste Spaltenleitung X1, XM über die Schaltstrecke des jeweiligen Spaltentransistors ST1, STM von einen Kanalleitungstyp, in Fig. 1 also ein N-Kanal-Transistor, mit dem Schaltungsnullpunkt verbunden. Jede zweite Spaltenleitung Y1, YM gehört zum entsprechenden Datenausgang DA1, DAM und ist mit dem Ausgang des jeweiligen Spalteninverters SI1, SIM verbunden. Dessen Schaltstrecke liegt einerseits am Schaltungsnullpunkt und andererseits am Potentialausgang der Spaltenpotential-Auswahl-schaltung PY und somit am Potential Uy.

Jeder einer Spalte zugeordnete Dateneingang DE1, DEM ist über die Schaltstrecke des jeweiligen ersten Spalten-Transmission-Gates SG11, SG1M mit dem Eingang des entsprechenden Spalteninverters SI1, SIM, verbunden. Der Eingang des Jeweiligen Spalteninverters SI1, SIM ist außerdem über die Schaltstrecke des jeweiligen zweiten Spalten-Transmission-Gate SG21, SG2M mit dem dritten Ausgang A3 des Komplexgatter KG verbunden und wird von dem Signal W0+St angesteuert.

Die Gates der den einen Kanalleitungstype aufweisenden Transistoren der ersten Spalten-Transmission-Gates SG11, SG1M, in Fig. 1 also deren N-Kanal-Transistoren, und die Gates der den anderen Kanalleitungstyp aufweisenden Transistoren der zweiten Spalten-Transmission-Gates SG21, SG2M, in Fig. 1 also deren P-Kanal-Transistoren, liegen am ersten Komplexgatterausgang a1 und werden von diesem dem Signal W1 angesteuert. Die Gates der den anderen Kanalleitungstyp aufweisenden, Transistoren der ersten Spalten-Transmission-Gates SG11, SG1M (in Fig. 1 P-Kanal-Transistoren) und die Gates der den einen Kanalleitungstyp aufweisenden Transistoren der zweiten Spalten-Transmission-Gates SG21, SG2M (in Fig. 1 N-Kanal-Transistoren) liegen am zweiten Komplexgatterausgang A2 und werden mit dem zum Signal W1 komplementären Signal $\overline{W1}$ angesteuert.

In Fig. 1 ist der am Potential Uy liegende Transistor des jeweiligen Spalteninverters SI1, SIM mit dem Bezugszeichen TL1, TLM versehen, was anzeigen soll, daß beim Lesen der Speicherzellen dieser Transistor zusammen mit dem Speichertransistor und dem Spaltentransistor ST1, STM in Serie liegt und somit einen Ratio-Inverter bildet, wobei der Transistor TL1, TLM dessen Lastwiderstand ist.

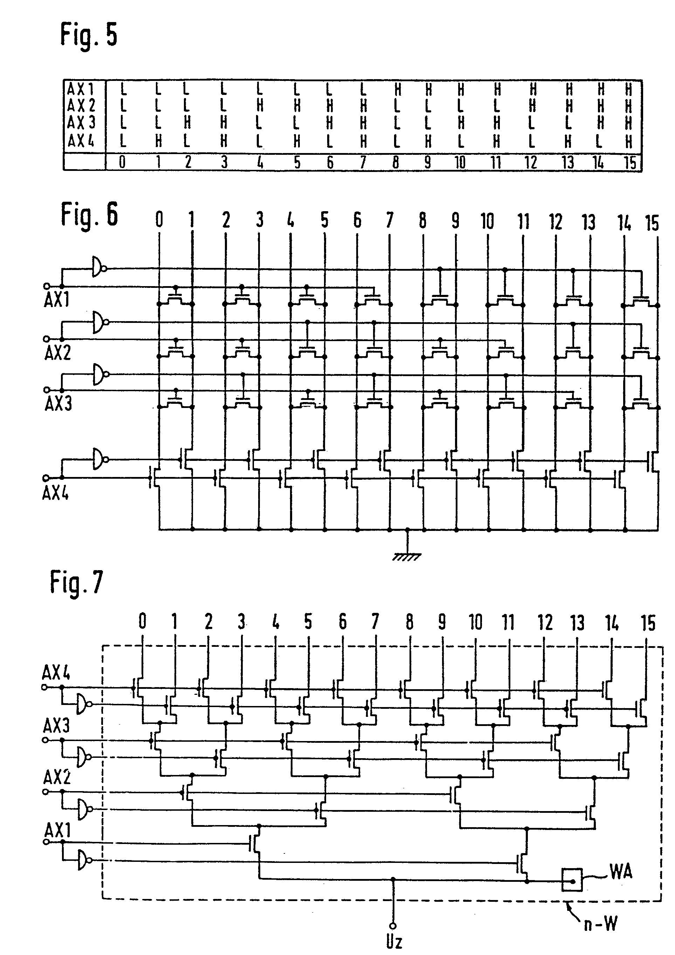

In den Fig. 6 und 7 sind zwei mögliche Schaltungsbeispiele für den Sperrdecoder SB bzw. den Kurzschlußdecoder KD nach Fig. 1 beispielhaft für daz Fall 1-aus-16 gezeigt. Es handelt sich dabei um übliche Schaltungen, deren Aufbau sich für den Fachmann aus den beiden Figuren ohne weiteres ergibt, so daß auf die ins Einzelne gehende Erläuterung hier verzichtet werden kann. Wie aus der Tabelle der Fig. 5 entnommen werden kann, handelt es sich bei diesen beiden Decodern um mit einem vierstelligen Binärsignal AX1 ... AX4 parallel ansteuerbare Eins-Aus-16-Decoder d.h. die Ausgänge können dezimal mit null bis fünfzehn bezeichnet werden. Die Tabelle der Fig. 5 gilt für Fig. 6 und 7 und zeigt für jeden der Ausgänge 0 ... 15 die entsprechende Adress AX1 ... AX4 im Binärcode.

Für die Erfindung wichtig ist, daß der Sperrdecoder SD aus Transistoren des einen Kanalleitungstyps, bei den in Fig. 1 für diesen Typ vorausgesetzten N-Kanal-Transistoren also ebenfalls aus N-Kanal-Transistoren, besteht, die im mit dem Schaltungsnullpunkt verbundenen Halbleiterkörper der integrierten Schaltung angeordnet sind. Sein Potentialeingang ist somit mit dem Schaltungnullpunkt verbunden, vgl. Fig. 1.

Für die Erfindung ist bezüglich des Kurzschlußdecoders KD ferner wichtig, daß er aus Transistoren des anderen Kanalleitungstyps, bei den in Fig. 1 für diesen Typ vorausgesetzten P-Kanal-Transistoren also auch aus P-Kanal-Transistoren, besteht, die innerhalb einer eigenen Isolierwanne n-W des Halbleiterkörpers der integrierten Schaltung angeordnet sind, die bei P-Kanal-Transistoren somit N-leitend ist. Der Potentialeingang des Kurzschlußdecoders KD liegt am Potentialausgang ZA der Zeilenpotential-Auswahlschaltung PZ und ist außerdem mit Isolierwanne n-W über deren Kontakt WA verbunden vgl. Fig. 7.

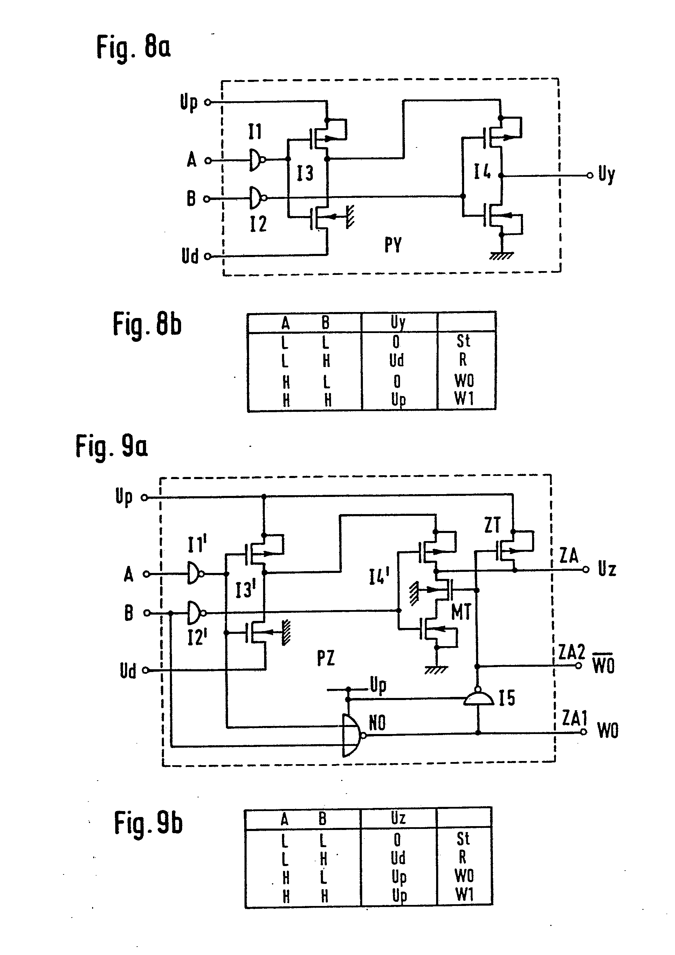

Die Fig. 8a zeigt ein bevorzugtes Ausführungsbeispiel für die Schaltung der Spaltenpotential-Auswahlschaltung PY. Sie besteht aus dem eingangsseitigen ersten bzw. zweiten Inverter I1, I2 und dem jeweils nachgeschalteten dritten bzw. vierten Inverter I3, I4. Dabei ist die Schaltstrecke des dritten Inverters zwischen den Eingang für die Betriebspannung Ud und den Eingang für die Programmierspannung Up geschaltet, wobei das Substrat des sourceseitig mit der Betriebsspannung Ud verbundenen Transistors am Schaltungsnullpunkt und das als Isolierwanne realisierte Substrat des sourceseitig an der Programmierspannung Up liegenden Transistors mit dessen Source verbunden ist. Die Schaltstrecke des vierten Inverters I4 liegt zwischen dem Schaltungsnullpunkt und dem Ausgang des dritten Inverters I3, wobei das durch eine eigene Isolierwanne realisierte Substrat des damit sourceseitig verbundenen Transistors auch an diesem Ausgang und das Substrat des anderen Transistors des vierten Inverters I4 am Schaltungsnullpunkt liegt. Dem Eingang des ersten Inverters I1 ist die erste Binärstelle A und dem Eingang des zweiten Inverters I2 die zweite Binärstelle B eines zweistelligen Binärsignals AB zugeführt, mit dem entsprechend der Tabelle in Fig. 8b das Ausgangspotential Uy für die vier Betriebsfälle St: Warten (stand by); R: Lesen; W0: Schreiben einer Null und W1: Schreiben einer Eins bestimmt werden kann.

Die Fig. 9a zeigt das Schaltbild einer bevorzugten Ausbildung der Zeilenpotential-Auswahschaltung nach Fig. 1. Sie besteht aus dem eingangsseitigen ersten bzw. zweiten Inverter I1', I2' und dem dem ersten Inverter I1' nachgeschalteten dritten Inverter 13', dessen Schaltstrecke zwischen der Betriebsspannung Ud und der Programmierspannung Up liegt, wobei das Substrat des sourceseitig an der Betriebsspannung Ud liegenden Transistors am Schaltungsnullpunkt und das also Isolierwanne realisierte Substrat des anderen Transistors an der Programmierspannung Up liegt und mit dessen Sourceanschluß verbunden ist. Der Ausgang des zweiten Inverters I2' liegt am Eingang eines derart modifizierten vierten Inverters I4', daß zwischen die Schaltstrecken seiner zwei source- und substratseitig am Schaltungsnullpunkt bzw. am Ausgang des dritten Inverters 13' liegenden Transistoren die Schaltstrecke des Zwischentransistors MT einegefügt ist. Sein Substrat, liegt am Schaltungsnullpunkt, und das Substrat des sourceseitig am Ausgang des dritten Inverters 13' liegenden Transistors ist durch eine eigene Isolierwanne realisiert und mit der Source dieses Transistors verbunden. Der Verbindungspunkt der Schaltstrecke des Zwischentransistors MT und des am Ausgang des dritten Inverters 13' liegenden Transistors ist der Potentialausgang ZA der Zeilenpotential-Auswahlschaltung PZ und über die Schaltstrecke des Zusatztransistors ZT mit der Programmierspannung Up verbunden.

Dem ersten Eingang des an der Programmierspannung Up als Versorgungsspannung liegenden NOR-Gatters NO ist die durch den ersten Inverter I1' invertierte erste Binärsignalstelle $\overline{A}$ und dem Eingang des zweiten Inverters I2' sowie dem zweiten Eingang des NOR-Gatters NO ist die zweite Binärsignalstelle B zugeführt. Der Ausgang des NOR-Gatters NO ist der erste Zusatz-Potentialausgang ZA1, der über den ebenfalls an der Programmierspannung Up als Versorgungsspannung liegenden fünften Inverter I5 den zweiten Zusatz-Potentialausgang ZA2 speist. Mit ihm sind die Gates von Zwischen- und Zusatztransistor MT, ZT verbunden, und es tritt an ihm das Potential W0 auf. Das dazu komplementäre Signal $\overline{W0}$ tritt am ersten Zusatz-Potentialausgang ZA1 auf.

In der Tabelle der Fig. 9b ist die Zuordnung der am Potentialausgang ZA1 auftretenden Spannungen Uz für die vier Zustände des Binärsignals AB gezeigt, wobei die Zustände St, R, W0, W1 dieselbe Bedeutung wie in der Tabelle nach Fig. 8b haben.

Die Potentialauswahlschaltungen nach den Fig. 8a und 9a stellen bestimmte bevorzugte Ausführungsbeispiele einer allgemeinen Klasse von Potentialauswahlschaltungen dar, wie sie in der gleichzeitig eingereichten europäischen Patentanmeldung mit dem Titel "Integrierte Auswahlschaltung in CMOS-Technik für vier Potentiale und deren Vereinfachungen für drei Potentiale" angegeben sind.

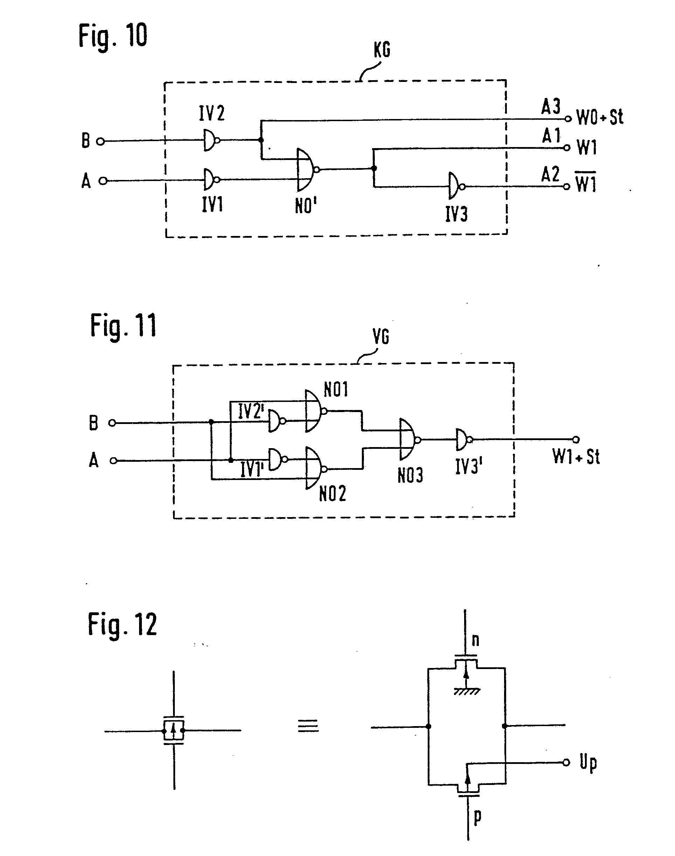

Die Fig. 10 zeigt das logische Schaltbild des Komplexgatters KG nach Fig. 1. Es besteht aus dem eingangsseitigen ersten und zweiten Inverter IV1, IV2, deren Ausgänge über das NOR-Gatter NO' zum ersten Komplexgatterausgang A1 führen, der das Signal W1 erzeugt. Aus diesem Signal wird mittels des dritten Inverters IV3 das dazu komplementäre Signal $\overline{W1}$ gebildet, das am zweiten Komplexgatterausgang A2 abgenommen werden kann. Der Ausgang des zweiten Inverters IV2 bildet schließlich den dritten Komplexgatterausgang A3 für das Signal W0+St. Am Eingang der ersten Inverters IV1 liegt die erste Binärsignalstelle A und am Eingang des zweiten Inverters IV2 die zweite Binärsignalstelle B.

Die von der Zeilenpotential-Auswahlschaltung PZ gelieferten Signale W0 und $\overline{W0}$ dienen dazu, die zwischen den ersten und zweiten Zeilenleitungen GX ... GY2.. über die Zeilen-Transmission-Gates ZG.. bestehende Verbindung zu unterbrechen und die ersten Zeilenleitungen GX.. an das Potential des Schaltungsnullpunkts zu legen.

Das Komplexgatter KG hat in Fig. 1 ebenso wie die ersten und zweiten Spalten-Transmission-Gates SG.. die Funktion, beim Schreiben mittels des Signals W1 die Eingangsdaten auf die Gates der Transistoren TL1, TLM durchzuschalten und beim Lesen (R) diese Gates gemeinsam auf das Potential des Schaltungsnullpunkts zu legen und damit das Ausgangspotential Uy der Spaltenpotential-Auswahlschaltung PY, das in diesem Fall gleich der Betriebsspannung Ud ist, auf elle ersten Spaltenleitungen Y.. durchzuschalten, die in allen anderen Betriebszuständen auf das Potential des Schaltungsnullpunkts durchgeschaltet sind.

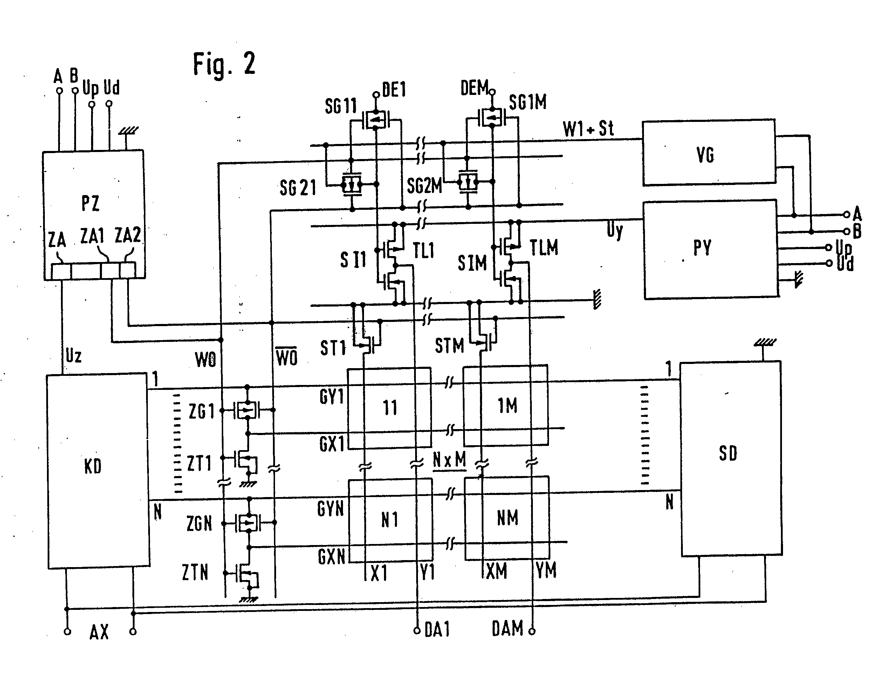

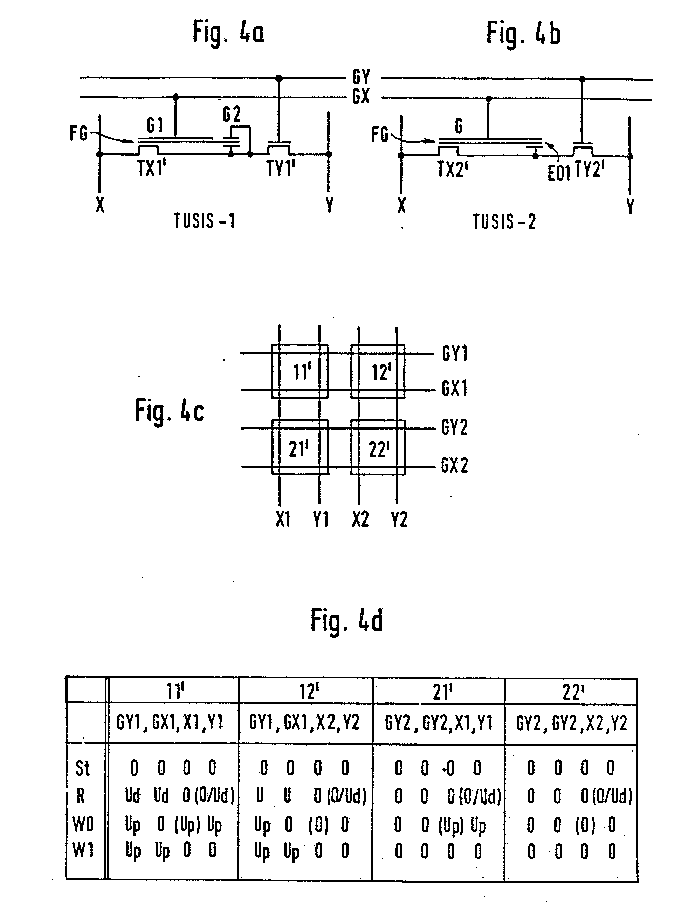

Die Fig. 2 zeigt ein dem Ausführungsbeispiel nach Fig. 1 weitgehend entsprechendes Ausführungsbeispiel für die eingangs erwähnten TUSIS-Speicherzellen, von denen zwei mögliche Varianten in den Fig. 4a und 4b gezeigt und dort mit TUSIS-1 bzw. TUSIS-2 bezeichnet sind. Die einzelne Speicherzelle besteht dabei aus dem Speichertransistor TX1' bzw. TX2' und dem zu dessen Schaltstrecke mit seiner Schaltstrecke in Serie geschalteten Auswahltransistor TY1' bzw. TY2'. Speicher- und Auswahltransistor sind vom gleichen Kanalleitungstyp; in den Fig. 2 und 4 ist dies der N-Typ. Die Serienschaltung der Schaltstrecken von Speicher- und Auswahltransistor liegt wiederum zwischen der speichertransistorseitigen ersten Spaltenleitung X, bzw. X1, X2 bzw. X1, XM und der zweiten Spalteinleitung Y bzw. Y1, Y2 bzw. Y1, YM.

Der Speichertransistor TX1' hat wiederum die beiden Gates G1, G2, wobei das erste an der ersten Zeilenleitung GX bzw. GX1, GX2 bzw. GX1, GXN liegt. Das zweite Gate G2 dient als äußere Tunnelelektrode zum Schreiben einer Null, die aber hier- im Gegensatz zu den TITEF-Speicherzellen von Fig. 3 zum Dateneinschreiben benützt wird. Die äussere Tunnelelektrode ist wie die ebenfalls kleinflächige innere Tunnelelektrode mit dem Verbindungspunkt von Speicher- und Auswahltransistor verbunden. Letztere dient zum Schreiben einer Eins, die hier zum Löschen verwendet wird.

In Fig. 4a hat der TUSIS-1-Speichertransistor für die beiden Tunnelstrecken nur einen äußeren Anschluß, da das zweite Gate G2 mit dem Verbindungspunkt von Speicher- und Auswahltransistor verbunden ist. Daraus leitet sich die Bezeichnung single injector ab. Das erste Gate G1 des Speichertransistors TX1' liegt an der ersten Zeilenleitung GX und das Gate des Auswahltransistors TY1' an der zweiten Zeilenleitung GY.

Bei der TUSIS-2-Speicherzelle nach Fig. 4b ist nur eine einzige Injektionsstrecke E01 vorhanden, da erstes und zweites Gate zum gemeinsamen Gate G vereinigt sind. Dieses liegt an der ersten Zeilenleitung GX und das Gate des Auswahltransistors TY2' an der zweiten Zeilenlietung GY. Die einzige Injektionsstrecke E01 wird von Tunnelelektronen beim Signal W0 von oben nach unten und beim Signal W1 von unten nach oben durchlaufen Die beim Tunneln von oben nach unten zu überwindende größere Tunnelstrom-Schwellenspannung kann nach der Voröffentlichung aus "Electronics" z.B. durch extrem dünnes, auf dem Einkreistallsubstrate gewachsenes Siliciumdioxid ausreichend neidrig gehalten werden. Bei der TUSIS-1-Speicherzelle nach Fig. 3a ist diese technologische Maßnahme nicht erforderlich, vielmehr sind sowohl für das Schreiben der Null (L) als auch für das Schreiben der Eins (H) zwei Tunnelstrecken E0 bzw. E1 durch das leichter durchtunnelbare Polysiliciumdioxid realisiert, die beide in gleicher Weise wie bei den TITEF-Speicherzellen der Fig. 3 von unten nach oben durchtunnelt werden.

Zu beiden TUSIS-Speicherzellen nach den Fig. 4a und 4b gehört das in Fig. 4c gezeigte Programmierschema, wobei nun jedoch der Zustand W0 Schreiben der Speicherzelle 11' und der Zustand W1 Löschen der Speicherzellen 11', 12' bedeutet Gegenüber dem Programmierschema in Fig. 3d sind also bezüglich W0, W1 die beiden Funktionen gerade vertauscht. Bei TUSIS-Speicherzellen wird also mit dem Signal W1 wortweise mit hoher Schwellenspannung gelöscht und mit dem Signal W0 bitweise eine niedere Schwellenspannung geschrieben.

In Fig. 2 sind die mit den Teilen der Fig. 1 identischen Teile mit denselben Bezugzeichen versehen. Es ist ersichtlich, daß lediglich anstatt des Komplexgatters KG nach Fig. 1 das Vielfachgatter VG in Fig. 2 vorgesehen ist, das nun lediglich das Signal W1+St erzeugen muß, an das die zweiten Spalten-Transmission-Gates SG21, SG2M angeschlossen sind. Die Ansteuerung der Gates dieser zweiten Spalten-Transmission-Gates erfolgt vom ersten bzw. zweiten Zusatz-Potentialausgang A1, A2 der Zeilenpotential-Auswahlschaltung PZ aus, also mittels der Signals W0, $\overline{W0}$.

In Fig. 11 ist das logische Schaltbild für das Vielfachgatter VG gezeigt. Es besteht aus je einem mit der ersten Binärsignalstelle A bzw. zweiten Binärsignalstelle B eingangsseitig gespeisten ersten und zweiten Inverter IV1', IV2', deren jeweiliger Ausgang zusammen mit dem Eingang des jeweils anderen Inverters über das erste und das zweite NOR-Gatter NO1, NO2 mit den beiden Eingängen des dritten NOR-Gatters NO3 verbunden ist, dessen Ausgang über den dritten Inverter IV3' an Vielfachgatterausgang liegt. Durch diese logische Verknüpfung entsteht an diesem Ausgang das Signal W1+St.

In Fig. 12 ist schließlich das ausführliche Schaltbild für die nach der Erfindung zu verwenden Transmission-Gates gezeigt, wenn N-Kanal-Speicherzellen verwendet werden. Dann ist das Substrat des P-Kanal-Transistors als Isolierwanne auszubilden und mit der Programmierspannung Up zu verbinden.

Ein weiterer Vorteil der erfindungsgemäßen Schaltungsanordnung besteht darin, daß sie keine einzelnen zu den Zeilen oder zu den Spalten gehörende Isolierwannen benötigt. Dadurch ergibt sich trotz ihrer Ausführung in CMOS-Technik ein sparsamer Flächenverbrauch und die Möglichkeit, eine hohe Bauelementdichte zu realisieren.

**Patentansprüche**

1. Integrierte Schaltungsanordnung zum Schreiben, Lesen und Löschen von Speichermatrizen (M×N) mit Isolierschicht-Feldeffekttransistoren nichtflücktigen Speicherverhaltens (TX ... , TX' ... ), dadurch gekennzeichnet, daß sie mittels Komplementär-Isolierschicht-Feldeffekttransistor-Invertern und -Transmission-Gates (CMOS-Invertern und CMOS-Transmission-Gates) sowie mittels eines Eins-Aus-N-Sperrdecoders (SD) und eines Eins-Aus-N-Kurzschluß-Decoders (KD), deren Adresseneingänge (AX) paarweise miteinander und deren gleichnamige Ausgänge über jeweils eine Zeilenleitung (GY ... ) der Speichermatrix (M×N) miteinander verbunden sind und die sich beim Programmieren der Speichermatrizen (M×N) zu Teilschaltungen mit CMOS-Inverter-Verhalten ergänzen, realisiert ist.

2. Schaltungsanordnung nach Anspruch 1, gekennzeichnet, durch folgende Merkmale:

— der Sperrdecoder (SD) besteht aus Transistoren des einen Kanalleitungstyps (N-Kanal in den Figuren), die in dem mit dem Schaltungsnullpunkt verbundenen Halbleiterkörper angeordnet sind, und sein Potentialeingang ist mit dem Schaltungsnullpunkt verbunden, und
— der Kurzschlußdecoder (KD) besteht aus Transistoren des anderen Kanalleitungstyps (P-Kanal in den Figuren), die innerhalb einer eigenen Isolierwanne (n-W) des einen Kanalleitungstyps angeordnet sind, und sein Potentialeingang ist mit dieser Isolierwanne (n-W) und mit dem Potentialausgang (ZA) einer Zeilenpotential-Auswahlschaltung (PZ) verbunden.

3. Schaltungsanordnung nach Anspruch 2 für Speichermatrizen (M×N), die pro Speicherzelle

(11, 1M, N1, NM) einen Speichertransistor (TX ... , TX'... ) des einen Kanalleitungstyps und einen üblichen Isolierschicht-Feldeffekttransistor als Auswahltransistor (TY ... , TY' ...) desselben Kanalleitungtyps aufweisen, die mit ihren Schaltstrecken in Serie zwischen einer speichertransistorseitigen ersten Spaltenleitung (X..) und einer zweiten Spaltenleitung (Y..) liegen, wobei der Speichertransistor (TX.., TX'..) zwei Gates (G1, G2) hat, deren erstens (G1) eine größere Fläche als das zweite (G2) aufweist und an der erstern (GX..) von zwei Zeilenleitungen (GX.., GY..) liegt und wobei während des Löschens bzw. Schreibens das zweite Gate (G2) als äußere Tunnelelektrode dient, der eine ebenfalls kleinflächige, mit dem Verbindungspunkt von Speicher- und Auswahltransistor verbundene, innere Tunnelelektrode für das Schreiben, bzw. Löschen zugeordnet ist, gekennzeichnet durch folgende Merkmale:

— die Schreib-, Lese- und Löschspannungen liefert für die Zeilen die Zeilenpotential-Auswahlschaltung (PZ) und für die Spalten eine Spaltenpotential-Auswahlschaltung (PY), die in Abhängigkeit von einem zweistelligen Binärsignal (A, B) entweder die Programmierspannung (Up) oder die Betriebsspannung (Ud) oder das Potential des Schaltungsnullpunkts an ihren Potentialausgang (ZA) durchschaltet, und
— die zweiten Zeilenleitungen (GY1, GYN) sind jeweils miteinander und über die Schaltstrecke jeweils eines Zeilen-Transmission-Gates (ZG1, ZGN) pro Zeile mit den entsprechenden ersten Zeilenleitungen (GX..) verbunden, die ihrerseits über die Schaltstrecke eines Zeilen-Transistors (ZT1, ZTN) des einen Kanalleitungstyps am Schaltungsnullpunkt liegen, wobei sein jeweiliges Gate und das des mit ihm jeweils einen CMOS-Inverter bildenden Transistors des Zeilen-Transmission-Gates (ZG1, ZGN) an einem ersten (ZA1) und das Gate des anderen Transistors des Zeilen-Transmission-Gates an einem zweiten Zusatz-Potentialausgang (ZA2) der Zeilenpotential-Auswahlschaltung (PZ) liegen, die zueinander komplementäre Signale (W0, $\overline{W0}$) liefern.

4. Schaltungsanordnung nach Anspruch 3 für TITEF-Speicherzellen (11, 12, 21, 22), wobei entweder die zweiten Gates (G2) der Speichertransistoren (TX1) an der zweiten Zeilenleitung (GY..) und das Gate der Auswahltransistoren (TY1) an der ersten Zeilenleitung (GX..) liegen oder die zweiten Gates (G2) der Speichertransistoren (TX2) und die Gates der Auswahltransistoren (TY2) gemeinsam an der zweiten Zeilenleitung (GY..) liegen, gekennzeichnet durch folgende Merkmale:

— das zweistellige Binärsignal (A, B) steuert ein Komplexgatter (KG) an, das aus je einem eingangsseitigen ersten bzw. zweiten Inverter (IV1, IV2) besteht, deren Ausgänge über ein NOR-Gatter NO') zum ersten Komplexgatterausgang (A1) führen, der über einen dritten Inverter (IV3) zum zweiten Komplexgatterausgang (A2) führt, während der Ausgang des zweiten Inverters (IV2) den dritten Komplexgatterausgang (A3) bildet,
— jede erste Spaltenleitung (X1, XM) ist über die Schaltstrecke jeweils eines Spaltentransistors (ST1, STM) des einen Kanalleitungstyps mit dem Schaltungnullpunkt verbunden, deren Gates am zweiten Komplexgatterausgang (A2) liegen,
— jede zweite Spaltenleitung (Y1, YM) gehört zum Datenausgang (DA1, DAM) und ist mit dem Ausgang jeweils eines Spalteninverters (SI1, SIM) verbunden, der mit seiner Schaltstrecke zwischen dem Schaltungsnullpunkt und dem Potentialausgang (Uy) der Spaltenpotential-Auswahlschaltung (PY) liegt, und
— jeder einer Spalte zugeordnete Dateneingang (DE1, DEM) ist jeweils über die Schaltstrecke eines ersten Spalten-Transmission-Gates (SG11, SG1M) mit dem jeweiligen Eingang des entsprechenden Spalteninverters (SI1, SIM) verbunden, dessen Eingang außerdem über die Schaltstrecke eines jeweils zugehörigen zweiten Spalten-Transmission-Gates (SG21, SG2M) mit dem dritten Komplexgatterausgang (A3) verbunden ist, wobei die Gates der den einen Kanalleitungs typ aufweisenden Transistoren der ersten Spalten-Transmission-Gates (SG11, SG1M) und die Gates der den anderen Kanalleitungstyp aufweisenden Transistoren der zweiten Spalten-Transmission-Gates (SG21, SG2M) am ersten Komplexgatterausgang (A1) liegen, während die Gates der den anderen Kanalleitungstyp aufweisenden Transistoren der ersten Spalten-Transmission-Gates und die Gates der den einen Kanalleitungstype aufweisenden Transistoren der zweiten Spalten-Transmission-Gates am zweiten Komplexgatterausgang (A2) liegen.

5. Schaltungsanordnung nach Anspruch 3, für TUSIS-Speicherzellen (11', 12', 21', 22'), wobei entweder das zweite Gate (G2) eines Speichertransistors (TX1') am Verbindungspunkt von Speichertransistor und Auswahl-transistors (TY1') und dessen Gate an der zweiten Zeilenleitung (GY..) liegt oder der Speichertransistor (TX2') nur ein großflächiges Gate (G) hat und das Gate des Auswahl-transistors (TY2') an der zweiten Zeilenleitung (GY..) liegt, gekennzeichnet durch folgende Merkmale:

— das zweistellige Binärsignal (A, B) steuert ein Vielfachgatter (VG), das aus je einem eingangsseitigen ersten bzw. zweiten Inverter (IV1', IV2') besteht, deren Ausgänge zusammen mit dem Eingang des jeweils anderen Inverters über ein erstes und ein zweites NOR-Gatter (NO1, NO2) zu den beiden Eingängen eines dritten NOR-

Gatters (NO3) führen, dessen Ausgang über einen dritten Inverter (IV3') am Vielfachgatterausgang liegt,

— jede erste Spantenleitung (X1, XM) ist über die Schaltstrecke jeweils eines Spaltentransistors (ST1, STM) des einen Kanalleitungstyps mit dem Schaltungsnullpunkt verbunden, deren Gates am zweiten Zusatz-Potentialausgang (ZA2) der Zeilenpotential-Auswahlschaltung (PZ) liegen,

— jede zweite Spaltenleitung (Y2, YM) ist mit dem Ausgang jeweils eines Spalteninverters (SI1, SIM) verbunden, der mit seiner Schaltstrecke zwischen dem Schaltungsnullpunkt und dem Potentialausgang (Uy) der Spaltenpotential-Auswahlschaltung (PY) liegt und

— jeder einer Spalte zugeordnete Dateneingang (DE1, DEM) ist über jeweils die Schaltstrecke eines ersten Spalten-Transmission-Gates (SG11, SG1M) mit dem jeweiligen Eingang des entsprechenden Spalteninverters (SI1, SIM) verbunden, dessen Eingang über die Schaltstrecke eines jeweils zugehörigen zweiten Spalten-Transmission-Gates (SG21, SG2M) mit dem Vielfachgatter-Ausgang verbunden ist, wobei die Gates der den einen Kanalleitungstyp aufweisenden Transistoren der ersten Spalten-Transmission-Gates (SG11, SG1M) und die Gates der den anderen Kanalleitungstyp aufweisenden Transistoren der zweiten Spalten-Transmission-Gates (SG21, SG2M) am ersten Zusatz-Potentialausgang (ZA1) der Zeilenpotential-Auswahlschaltung (PZ) liegen, während die Gates der den anderen Kanalleitungstyp aufweisenden Transistoren der ersten Spalten-Transmission-Gates und die Gates der den einen Kanalleitungstyp aufweisenden Transistoren der zweiten Spalten-Transmission-Gates am zweiten Zusatz-Potentialausgang (ZA2) der Zeilenpotential-Auswahlschaltung (PZ) liegen.

6. Schaltungsanordnung nach einem der Ansprüche 3 bis 5, gekennzeichnet durch folgende Merkmale:

— die Spaltenpotential-Auswahlschaltung (PY) besteht aus einem eingangsseitigen ersten bzw. zweiten Inverter (I1, I2) mit jeweils nachgeschaltetem dritten bzw. vierten Inverter (I3, I4),

— die Schaltstrecke des dritten Inverters (I3) liegt zwischen der Betriebsspannung (Ud) und der Programmierspannung (Up), wobei das Substrat des sourceseitig mit der Betriebsspannung (Ud) verbundenen Transistors am Schaltungsnullpunkt und das als Isolierwanne realisierte Substrat des anderen Transistors mit dessen Source verbunden ist und an der Programmierspannung (Up) liegt, und

— die Schaltstrecke des vierten Inverters (I4) liegt zwischen dem Schaltungsnullpunkt und dem Ausgang des dritten Inverters (I3), wobei das durch eine eigene Isolierwanne realisierte Substrat des damit sourceseitig verbundenen Transistors auch an diesem Ausgang und das Substrat des anderen Transistors am Schaltungsnullpunkt liegt.

7. Schaltungsanordnung nach einem der Ansprüche 3 bis 5, gekennzeichnet durch folgende Merkmale:

— die Zeilenpotential-Auswahlschaltung (PZ) besteht aus einem eingangsseitigen ersten bzw. zweiten Inverter (I1', I2'), deren Eingängen die erste (A) bzw. die zweite Stelle (B) des Binärsignals zugeführt sind, und einem dem ersten Inverter (I1') nachgeschalteten dritten Inverter (I3'), dessen Schaltstrecke zwischen der Betriebsspannung (Ud) und der Programmierspannung (Up) liegt, wobei das Substrat des sourceseitig an der Betriebsspannung (Ud) liegenden Transistors am Schaltungsnullpunkt und das als Isolierwanne realisierte Substrat des anderen Transistors mit dessen Sourceanschluß verbunden ist und an der Programmierspannung (Up) liegt,

— der Ausgang des zweiten Inverters (I2') liegt am Eingang eines derart modifizierten vierten Inverters (I4'), daß zwischen die Schaltstrecken seiner zwei source- und substratseitig am Schaltungsnullpunkt bzw. am Ausgang des dritten Inverters (I3') liegenden Transistoren die Schaltstrecke eines Zwischentransistors (MT) eingefügt ist, dessen Substrat am Schaltungsnullpunkt liegt, wobei das Substrat des am Ausgang des dritten Inverters (I3') liegenden Transistors durch eine eigene Isolierwanne realisiert ist,

— der Verbindungspunkt der Schaltstrecken des Zwischentransistors (MT) und des am Ausgang des dritten Inverters (I3') liegenden Transistors ist der Potentialausgang (ZA) der Zeilenpotential-Auswahlschaltung (PZ) und ist über die Schaltstrecke eines Zusatztransistors (ZT) mit der Programmierspannung (Up) verbunden,

— der erste Eingang eines an der Programmierspannung (Up) als Versorgungsspannung liegenden NOR-Gatters (NO) liegt am Ausgang des ersten Inverters (I1) und der zweite Eingang des NOR-Gatters (NO) ist mit dem Eingang des zweiten Inverters (I2) verbunden,

— der Ausgang der NOR-Gatters (NO) ist zugleich der erste Zusatz-Potentialausgang (ZA1) und speist über einen ebenfalls an der Programmierspannung (Up) als Versorgungsspannung liegenden fünften Inverter (I5') den zweiten Zusatz-Potentialausgang (ZA2), und

— die Gates von Zwischen- und Zusatztransistor (MT, ZT) liegen an zweiten Zusatz-Potentialausgang (ZA2).

8. Schaltungsanordnung nach einem der Ansprüche 3 bis 7, dadurch gekennzeichnet, daß die Isolierwanne, worin der den anderen Kanalleitungstyp aufweisende Transistor der jeweiligen Transmission-Gates angeordnet ist, mit der Programmierspannung (Up) verbunden ist.

## Revendications

1. Arrangement de circuits intégrés pour l'écriture, la lecture et l'effacement de matrices de mémoire (M×N) à transistors à effet de champ à grille isolée à comportement non volatil (TX ..., TX'...), caractérisé en ce qu'il est réalisé à l'aide d'inverseurs et de portes de transmission complémentaires à transistors à effet de champ à grille isolée (inverseurs CMOS et portes de transmission CMOS) et d'un décodeur 1 parmi N à circuit ouvert (SD) et d'un décodeur 1 parmi N à court-circuit (KD) dont les entrées d'adressage (AX) sont appairées entre elles et dont les sorties de même rang sont interconnectées par l'intermédiaire d'un ligne de rangée (GY ...) de la matrice de mémoire (M×N) et, lors de la programmation des matrices de mémoire (M×N), se complètent pour donner des éléments de circuits à comportement d'inverseur CMOS.

2. Arrangement de circuits intégrés selon la revendication 1, caractérisé en ce que le décodeur à circuit ouvert (SD) se compose de transistors d'un type de conductibilité (canal N sur les figures) disposés dans le corps semi-conducteur relié au zéro du circuit et à une entrée de potentiel reliée au zéro du circuit et en ce que le décodeur à court-circuit (KD) se compose de transistors de l'autre type de conductibilité (canal P sur les figures) disposés à l'intérieur d'une cuvette d'isolation propre (n-W) du premier type de conductibilité et a une entrée de potentiel reliée à cette cuvette d'isolation (n-W) et à la sortie de potentiel (ZA) d'un circuit de sélection de potentiel de ligne (PZ).

3. Arrangement de circuits selon la revendication 2 pour des matrices de mémoire (M×N) possédant par cellule de mémoire (11, 1M, N1, NM) un transistor de mémoire (TX..., TX'...) d'un type donné de canal et un transistor à effet de champ à grille isolée de type courant comme transistor de sélection (TY . ., TY' . .) du même type de canal, dont les voies de commutation sont montées en série entre une première ligne de colonne (X...) côté transistor de mémoire et une seconde ligne de colonne (Y...), où le transistor de mémoire (TX . ., TX' . .) possède deux grilles (G1, G2), dont la première (G1) présente une plus grande surface que la seconde (G2) et est reliée à la première (GX...) des deux lignes de rangée (GX . ., GY . .) et où, pendant l'effacement on l'écriture, la seconde grille (G2) sert d'électrode tunnel extérieur à laquelle correspond une électrode tunnel intérieur pour l'effacement ou l'écriture également de petite surface, reliée au point de liaison du transistor de mémoire et du transistor de sélection, caractérisé en ce que les tensions d'écriture, de lecture et d'effacement pour les rangées sont fournies par le circuit de sélection du potentiel de rangée (PZ) et pour les colonnes par un circuit de sélection de potentiel de colonne (PY) qui, en fonction d'un signal binaire à deux chiffres (A, B), commute à sa sortie de potentiel (ZA) soit la tension de programmation (Up), soit la tension de service (Ud), soit le potentiel du zéro du circuit et en ce que les secondes lignes de rangées (GY1, GYN) sont reliées entre elles et, par la voie de commutation d'une porte de transmission de ligne (ZG1, ZGN) individuellement à la première ligne de rangée correspondante (GX...), laquelle, à son tour, est reliée au zéro du circuit via la voie de commutation d'un transistor de rangée (ZT1, ZTX) à canal du premier type, la grille de ce dernier et celle du transistor formant avec lui un inverseur CMOS de la porte de transmission de ligne (ZG1, ZGN) étant reliée à une première sortie de potentiel supplémentaire (ZA1) et la grille de l'autre transistor de la porte de transmission de ligne étant raccordée à une seconde sortie de potentiel supplémentaire (ZA2) du circuit de sélection de potentiel de ligne (PZ), qui fournissent des signaux complémentaires (W0, $\overline{W0}$).

4. Arrangement de circuits selon la revendication 3 pour cellules de mémoire TITEF (11, 12, 21, 22) où soit les secondes grilles (G2) des transistors de mémoire (TX1) sont reliées à la second ligne de rangée (GY...) et la grille du transistor de sélection (TY1) à la première ligne de rangée (GX . .), soit les secondes grilles (G2) des transistors de mémoire (TX2) et les grilles des transistors de sélection (TY2) sont reliées ensemble à la seconde ligne de rangée (GY...), caractérisé en ce que le signal binaire à deux chiffres (A, B) attaque une porte complexe (KG) composée côté entrée d'un premier et d'un second inverseurs (IV1, IV2) dont les sorties, par l'intermédiaire d'une porte OU-NON (NO'), arrivent à la première sortie de la porte complexe (A1) qui, par l'intermédiaire d'un troisième inverseur (IV3), arrive à la seconde sortie de la porte complexe (A2), tandis que la sortie du second inverseur (IV2) forme la troisième sortie de la porte complexe (A3), en ce que chaque première ligne de colonne (X1, XM) est reliée au zéro du circuit par l'intermédiaire de la voie de commutation d'un transistor de colonne (ST1, STM), à canal du premier type dont les grilles sont reliées à la seconde sortie de la porte complexe (A2), en ce que chaque seconde ligne de colonne (Y1, YM) appartient à une sortie de données (DA1, DAM) et est reliée à la sortie d'un inverseur de colonne (SI1, SIM) dont la voie de commutation est placée entre le zéro du circuit et la sortie de potentiel (Uy) du circuit de sélection de potentiel de colonne (PY), et en ce que chaque entrée de données correspondant à une colonne (DE1, DEM), par la voie de commutation d'un première porte de transmission de colonne (SG11, SG1M), est reliée à l'entrée de l'inverseur de colonne correspondant (SI1, SIM), dont l'entrée est en outre reliée par la voie de commutation d'une seconde porte de transmission de colonne correspondante (SG21, SG2M) à la troisième sortie de la porte complexe (A3), les grilles des transistors à canal du premier type de la première porte de transmission de colonnes (SG11, SG1M) et les grilles des transistors à canal de l'autre type de la seconde porte de transmission de colonne (SG21, SG2M) étant reliées à la première sortie de la

porte complexe (A1), tandis que les grilles de transistors à canal de l'autre type de la première porte de transmission de colonnes et les grilles des transistors à canal du premier type de la seconde porte de transmission de colonne sont reliées à la seconde sortie de la porte complexe (A2).

5. Arrangement de circuits selon la revendication 3 pour cellules de mémoire TUSIS (11', 12', 21', 22'), où soit la seconde grille (G2) d'un transistor de mémoire (TX1') est reliée au point de liaison du transistor de mémoire (TX . ., TX' . .) et d'un transistor de sélection (TY1') dont la grille est reliée à la seconde ligne de rangée (GY...), soit le transistor de mémoire (TX2') ne présente qu'une seule grille de grande surface (G) et où la grille du transistor de sélection (TY2') est reliées à la seconde ligne de rangée (GY...), caractérisé en ce que le signal binaire à deux chiffres (A, B) attaque une porte multiple (VG) composée côté entrée d'un premier et d'un second inverseurs (IV1', IV2') dont les sorties, avec l'entrée de l'autre inverseur, mènent par l'intermédiaire d'une première et d'une seconde porte OU-NON (NO1, NO2), aux deux entrées d'une troisième porte OU-NON (NO3) dont la sortie arrive à la sortie de la porte multiple par un troisième inverseur (IV3'), en ce que chaque première ligne de colonne (X1, XM) est reliée au zéro du circuit par l'intermédiaire de la voie de commutation d'un transistor de colonne (ST1, STM) à canal du premier type dont les grilles sont reliées à la seconde sortie de potentiel supplémentaire (ZA2) du circuit de sélection de potentiel de ligne (PZ), en ce que chaque seconde ligne de colonne (Y2, YM) est reliée à la sortie d'un inverseur de colonne (SI1, SIM) dont la voie de commutation est placée entre le zéro du circuit et la sortie de potentiel (Uy) du circuit de sélection de potentiel de colonne (PY), et en ce que chaque entrée de données correspondant à une colonne (DE1, DEM), par la voie de commutation d'une première porte de transmission de colonne (SG11, SG1M), est reliée à l'entrée de l'inverseur de colonne correspondant (SI1, SIM), dont l'entrée est reliée par la voie de commutation d'une seconde porte de transmission de colonne correspondante (SG21, SG2M) à la sortie de la porte multiple (VG), les grilles des transistors à canal du premier type de la première porte de transmission de colonnes (SG11, SG1M) et les grilles des transistors à canal de l'autre type de la seconde porte de transmission de colonne (SG21, SG2M) étant reliées à la première sortie de potentiel supplémentaire (ZA1) tandis que les grilles des transistors à canal de l'autre type de la première porte de transmission de colonnes et les grilles de transistors à canal du premier type de la seconde porte de transmission de colonnes sont reliées à la seconde sortie de potentiel supplémentaire (ZA2) du circuit de sélection de potentiel de ligne (PZ).

6. Arrangement de circuits selon l'une des revendications 3 à 5, caractérisé en ce que le circuit de sélection de potentiel de colonne (PY) se compose côté entrée d'un premier et d'un second

inverseurs (I1, I2) et d'un troisième et d'un quatrième inverseurs (I3, I4) montés en aval, en ce que voie de commutation du troisième inverseur (I3) est disposée entre la tension de service (Ud) et la tension de programmation (Up), le substrat du transistor reliée côté source avec la tension de service (Ud) étant relié au zéro du circuit et le substrat de l'autre transistor, réalisé sous forme de cuvette d'isolation, étant relié à sa source et à la tension de programmation (Up), et en ce que la voie de commutation du quatrième inverseur (I4), est situé entre le zéro du circuit et la sortie du troisième inverseur (I3), le substrat réalisé par une cuvette d'isolation du transistor relié côté source à cette sortie lui étant également relié et le substrat de l'autre transistor étant au zéro du circuit.

7. Arrangement de circuits selon l'une des revendications 3 à 5, caractérise en ce que le circuit de sélection de potentiel de ligne (PZ) se compose côté entrée d'un premier et d'un second inverseur (I1', I2') dont les entrées reçoivent la première (A) et la seconde (B) position du signal binaire et d'un troisième inverseur (I3') monté en aval du premier (I1') dont la voie de commutation est située entre la tension de service (Ud) et la tension de programmation (Up), le substrat du transistor relié côté source à la tension de service (Ud) étant relié au zéro du circuit et le substrat réalisé sous forme de cuvette d'isolation de l'autre transistor étant relié à son raccordement de source et à la tension de programmation (Up), en ce que la sortie du second inverseur (I2') est reliée à l'entrée d'un quatrième inverseur (I4') modifié de manière à avoir, entre les voies de commutation de ses deux transistors raccordés côté source et côté substrat au zéro du circuit ou à la sortie du troisième inverseur (I3'), la voi de commutation d'un transistor intermédiaire (MT), dont le substrat est relié au zéro du circuit, le substrat du transistor relié à la sortie du troisième inverseur (I3') étant réalisé par un cuvette d'isolation propre, en ce que le point de connexion des voies de commutation du transistor intermédiaire (MT) et du transistor relié à la sortie du troisième inverseur (I3') est la sortie de potentiel (ZA) du circuit de sélection de potentiel de ligne (PZ) et est reliée par la voie de commutation d'un transistor supplémentaire (ZT) à la tension de programmation (Up), en ce que la première entrée d'une porte OU-NON (NO) reliée à la tension programmation (Up) comme tension de service est reliée à la sortie du premier inverseur (I1') et que la seconde entrée de la porte OU-NON (NO) est reliée à l'entrée du second inverseur (I2), en ce que la sortie de la porte OU-NON (NO) est également la première sortie de potentiel supplémentaire (ZA1) et alimente, par l'intermédiaire d'un cinquième inverseur (I5) également raccordé à la tension de programmation (Up) comme tension d'alimentation, la seconde sortie de potentiel supplémentaire (ZA2), et en ce que les grilles du transistor intermédiaire (MT) et du transistor supplémentaire (ZT) sont reliées à la seconde sortie de potentiel supplémentaire (ZA2).

8. Arrangement de circuits selon l'une des revendications 3 à 7, caractérisé en ce que la cuvette d'isolation dans laquelle sont disposés les transistors à canal de l'autre type de chaque porte de transmission sont reliées à la tension de programmation (Up).

**Claims**

1. Integrated circuit for writing, reading and erasing memory matrices (M×N) with insulated-gate field-effect transistors having a non-volatile storage behaviour (TX..., TX'...), characterized in that it is realized by means of complementary insulated-gate field-effect transistor inverters and transmission gates (CMOS intervers and CMOS transmission gates) as well as of an open-circuit one-ex-N-decoder (SD) and a short-circuit one-ex-N-decoder (KD) whose address inputs (AX) are connected in pairs with one another and whose like outputs are connected with one another via respectively one row line (GY...) of the memory matrix (M×N) and which, during, the programming of the memory matrices (M×N) are completed to form partial circuits having CMOS-inverter behaviour.

2. A circuit as claimed in claim 1, characterized by the following features:

— the open circuit decoder (SD) consists of transistors of the one channel-conductivity type (n-channel in the drawings) which are arranged in the semiconductor body as connected to the zero point of the circuit, and its potential input is connected to the zero point of the circuit, and

— the short-circuit decoder (KD) consists of transistors of the other channel conductivity type (p-channel in the drawings) which are arranged within a separate insulating island (n-W) of the one channel conductivity type and its potential input is connected to this insulating island (n-W) and to the potential output (ZA) of a row potential selection circuit (PZ).

3. A circuit as claimed in claim 2 for memory matrices (M×N) which, per memory cell (11, 1M, N1, NM), comprises one storage transistor (TX..., TX'...) of the one channel conductivity type and a usual type of insulated-gate field-effect transistor as the select transistor (TY..., TY'...) of the same channel conductivity type which, with their switching sections, are arranged in series between a storage transistor sided first column line (X...) and a second column line (Y...), with said storage transistor (TX..., TX'...) having two gates (G1, G2) of which the first one (G1) has a larger surface area than the second one (G2), and is applied to the first one (GX...) of two row lines (GX..., GY...), and with the second gate (G2), during the erase or writing operation, serving as an external tunnel electrode to which there is associated a likewise small-area internal tunnel electrode connected to the point connecting the storage and the select transistor, for effecting the writing or the erasing operation, characterized by the following features:

— the writing, reading and erasing voltages for the rows are supplied by the row potential selection circuit (PZ), and for the columns by the column potential selection circuit (PY) which, in dependence upon a two-bit signal (A, B) effects the connecting through of either the programming voltage (Up) or the operating voltage (Ud), or connects the potential of the zero point of the circuit to its potential output (ZA), and

— the second row lines (GY1, GYN) are respectively connected to one another and, via the switching section of each time one row transmission gate (ZG1, ZGN), are connected per row to the corresponding first row lines (GX...) which, in turn, and via the switching section of a row transistor (ZT1, ZTN) of the one channel conductivity type, are applied to the zero point of the circuit, with the respective gate thereof and the gate of the transistor of the row transmission gate (ZG1, ZGN) respectively forming a CMOS inverter therewith, being applied to a first additional potential output (ZA1) and with the gate of the other transistor of the row transmission gate being applied to a second additional potential output (ZA2) of said row potential selection circuit (PZ), supplying signals (W0, $\overline{W0}$) being complementary in relation to one another.

4. A circuit as claimed in claim 3 for TITEF memory cells (11, 12, 21, 22), with either the second gates (G2) of the storage transistors (TX1) being connected to the second row line (GY...) and the gate of the select transistors (TY1) being applied to the first row line (GX...), or the second gates (G2) of the storage transistors (TX2) and the gates of the select transistors (TY2) being connected jointly to the second row line (GY...), characterized by the following features:

— the two-bit signal (A, B) activates a complex gate (KG) consisting of each time one input-sided first or second inverter (IV1, IV2) with the outputs thereof extending via a NOR gate (NO') to the first complex gate output (A1) which, via a third inverter (IV3) extends to the second complex gate output (A2), while the output of said second inverter (IV2) forms the third complex gate output (A3),

— every first column line (X1, XM) is connected via the switching section of respectively one column transistor (ST1, STM) of the one channel conductivity type, to the zero point of the circuit, while the gates thereof are connected to the second complex gate output (A2),

— every second column line (Y1, YM) belongs to the data output (DA1, DAM) and is connected to the output of each time one column inverter (SI1, SIM) which, with its switching section, is arranged between the zero point of the circuit and the potential output (Uy) of the column potential selection circuit (PY), and

— each data input (DE1, DEM) associated with one column, is connected respectively via the switching section of a first column transmission gate (SG11, SG1, SGM), to the respective input of the corresponding column inverter (SI1, SIM) with the input thereof, moreover, via the switching section of a respectively associated second column transmission gate (SG21, SG2M) being connected to the third complex gate output (A3), with the gates of the transistors of the first column transmission gates SG11, SG1M) and of the one channel conductivity type, and the gates of the transistors of the second column transmission gates (SG21, SG2M) and of the other channel conductivity type, being connected to the first complex gate output (A1), while the gates of the transistors of the first column transmission gates are of the other channel conductivity type, and with the gates of the transistors of the second column transmission gates are of the one channel conductivity type, being connected to the second complex gate output (A2).

5. A circuit as claimed in claim 3, for TUSIS memory cells (11', 12', 21', 22'), in which either the second gate (G2) of a storage transistor (TX1') is connected to the point connecting the storage transistor and the select transistor (TY1'), with the gate thereof being connected to the second row line (GY...), or the storage transistor (TX2') only has one large-area gate (G) and the gate of the select transistor (Ty2') is connected to the second row line (Gy...), characterized by the following features:

— the two-bit signal (A, B) controls a multiple gate (VG) consisting of each time one input-sided first or second inverter (IV1', IV2') with the outputs thereof, together with the input of the respective other inverter, and via a first and a second NOR gate (NO1, NO2), extending into the two inputs of a third NOR gate (NO3) whose output is connected via a third inverter (IV3') to the multiple gate output,
— every first column line (X1, XM) is connected via the switching section of each time one column transistor (ST1, STM) of the one channel conductivity type to the zero point of the circuit, with the gates thereof being connected to the second additional potential output (ZA2) of the row potential selection circuit (PZ),
— every second column line (Y2, YM) is connected to the output of each time one column inverter (SI1, SIM) which with its switching section, is arranged between the zero point of the circuit and the potential output (Uy) of the column potential selection circuit (PY) and
— each data input (DE1, DEM) which is associated with one column, is connected via respectively the switching section of a first column transmission gate (SG11, SG1M) to the respective input of the corresponding column inverter (SI1, SIM) whose input, via the switching section of a respectively associated second column transmission gate (SG21, SG2M), is connected to the multiple gate output, with the gates of the transistor of the first column transmission gates (SG11, SG1M) being of the one channel conductivity type, and the gates of the transistors of the second column transmission gates (SG21, SG2M) and of the other channel conductivity type, being connected to the first additional potential output (ZA1) of the row potential selection circuit (PZ), while the gates of the transistors of the first column transmission gates and of the other channel conductivity type, and the gates of the transistors of the second column transmission gates and of the one channel conductivity type, being applied to the second additional potential output (ZA2) of the row potential selection circuit (PZ).

6. A circuit as claimed in any one of claims 3 to 5, characterized by the following features:

— the column potential selection circuit (PY) consists of an input-sided first or second inverter (I1, I2) with a respectively subsequently arranged third or fourth inverter (I3, I4),
— the switching distance of the third inverter (I3) is arranged between the operating voltage (Ud) and the programming voltage (Up), with the substrate of the transistor which is connected with its source to the operating voltage (Ud) being connected to the zero point of the circuit, and the substrate of the other transistor which is realized as an insulating island, being connected to the source thereof, and to the programming voltage (Up), and
— the switching section of the fourth inverter (I4) is arranged between the zero point of the circuit and the output of the third inverter (I3), with the substrate as realized by a separate insulating island, of the transistor connected thereto with its source, also being connected to this output while the substrate of the other transistor is connected to the zero point of the circuit.

7. A circuit as claimed in any one of claims 3 to 5, characterized by the following features:

— the row potential selection circuit (PZ) consists of an input-sided first or second inverter (I1', I2') to the inputs thereof there is fed the first (A) or the second bit (B) of the binary signal, and of a third inverter (I3') arranged subsequently to said first inverter (I1'), with the switching section thereof being arranged between the operating voltage (Ud) and the programming voltage (Up), with the substrate of the transistor connected with its source to the operating voltage (Ud), being connected to the zero point of the circuit and the substrate, realized as an insulating island, of the other transistor, being connected to the source terminal thereof and to the programming voltage (Up),

— the output of the second inverter (I2') is connected to the input of a fourth inverter (I4') which is modified in such a way that between the switching sections of its two transistors which are connected with their source and substrate sides to the zero point of the circuit or to the output of the third inverter (I3') respectively, there is inserted the switching section of an intermediate transistor (MT) whose substrate is connected to the zero point of the circuit, with the substrate of the transistor as connected to the output of the third inverter (3') being realized by a separate insulating island,

— the point connecting the switching sections of the intermediate transistor (MT) and the transistor as connected to the output of the third inverter (I3') forms the potential output (ZA) of the row potential selection circuit (PZ) and is connected to the programming voltage (Up) via the switching section of an additional transistor (ZT),

— the first input of a NOR gate (NO) as applied to the programming voltage (Up) serving as the supply voltage, is connected to the output of the first inverter (I1), and the second input of said NOR gate (NO) is connected to the input of the second inverter (I2),

— the output of the NOR gate (NO) is simultaneously the first additional potential output (ZA1) and, via a fifth inverter (I5') which is likewise connected to the programming voltage (Up) serving as the supply voltage, feeds the second additional potential output (ZA2), and

— the gates of said intermediate transistor and said additional transistor (MT, ZT) are connected to said second additional potential output (ZA2).

8. A circuit as claimed in any one of claims 3 to 7, characterized in that said insulating island in which the transistor of the respective transmission gate, being of the other channel conductivity type, is arranged, is connected to the programming voltage (Up).

Fig. 1

Fig. 2

0 061 512

## Fig. 3a

TITEF - 1

## Fig. 3b

TITEF - 2

## Fig. 3c

## Fig. 3d

|  | 11 | 12 | 21 | 22 |
|---|---|---|---|---|
|  | GY1,GX1,X1,Y1 | GY1, GX1,X2,Y2 | GY2,GX2,X1,Y1 | GY2,GX2,X2,Y2 |
| St | 0   0   0   0 | 0   0   0   0 | 0   0   0   0 | 0   0   0   0 |
| R | Ud  Ud  0 (0/Ud) | Ud  Ud  0 (0/Ud) | 0   0   0 (0/Ud) | 0   0   0 (0/Ud) |
| W0 | Up  0   0   0 | Up  0   0   0 | 0   0   0   0 | 0   0   0   0 |
| W1 | Up  Up  (0)  0 | Up  Up  (Up) Up | 0   0   (0)  0 | 0   0   (Up) Up |

3

## Fig. 4a

GY
GX

FG  G1  G2

TX1'  TY1'

X  Y

TUSIS-1

## Fig. 4b

GY
GX

FG  G

TX2'  E01 TY2'

X  Y

TUSIS-2

## Fig. 4c

| 11' | 12' | GY1 |
| 21' | 22' | GX1 |

GY1

GX1

GY2

GX2

X1  Y1  X2  Y2

## Fig. 4d

| | 11' | | | | 12' | | | | 21' | | | | 22' | | | |
|---|---|---|---|---|---|---|---|---|---|---|---|---|---|---|---|---|
| | GY1, GX1, X1, Y1 | | | | GY1, GX1, X2, Y2 | | | | GY2, GY2, X1, Y1 | | | | GY2, GY2, X2, Y2 | | | |
| St | 0 | 0 | 0 | 0 | 0 | 0 | 0 | 0 | 0 | 0 | 0 | 0 | 0 | 0 | 0 | 0 |
| R | Ud | Ud | 0 | (0/Ud) | U | U | 0 | (0/Ud) | 0 | 0 | 0 | (0/Ud) | 0 | 0 | 0 | (0/Ud) |
| W0 | Up | 0 | (Up) | Up | Up | 0 | (0) | 0 | 0 | 0 | (Up) | Up | 0 | 0 | (0) | 0 |
| W1 | Up | Up | 0 | 0 | Up | Up | 0 | 0 | 0 | 0 | 0 | 0 | 0 | 0 | 0 | 0 |

4

## Fig. 5

| AX1 | L | L | L | L | L | L | L | L | H | H | H | H | H | H | H | H |
|-----|---|---|---|---|---|---|---|---|---|---|---|---|---|---|---|---|
| AX2 | L | L | L | L | H | H | H | H | L | L | L | L | H | H | H | H |
| AX3 | L | L | H | H | L | L | H | H | L | L | H | H | L | L | H | H |
| AX4 | L | H | L | H | L | H | L | H | L | H | L | H | L | H | L | H |
|     | 0 | 1 | 2 | 3 | 4 | 5 | 6 | 7 | 8 | 9 | 10 | 11 | 12 | 13 | 14 | 15 |

## Fig. 6

## Fig. 7

## Fig. 8a

## Fig. 8b

| A | B | Uy | |
|---|---|----|----|
| L | L | 0 | St |
| L | H | Ud | R |
| H | L | 0 | W0 |
| H | H | Up | W1 |

## Fig. 9a

## Fig. 9b

| A | B | Uz | |
|---|---|----|----|
| L | L | 0 | St |
| L | H | Ud | R |
| H | L | Up | W0 |
| H | H | Up | W1 |

Fig. 10

KG

IV2

IV1

NO'

IV3

B

A

A3    W0+St

A1    W1

A2    $\overline{W1}$

Fig. 11

VG

IV2'

IV1'

NO1

NO2

NO3

IV3'

B

A

W1+St

Fig. 12

≡

n

p

Up